# EUROPEAN PATENT SPECIFICATION

(11) **EP 0 660 377 B1**
(45) Date of publication and mention of the grant of the patent: **03.09.1997**
(21) Application number: 94118557.1
(22) Date of filing: 25.11.1994
(51) Int. Cl.: H01L 21/00, B25B 11/00

(54) **Method for applying a wafer to a mount plate**
Verfahren zur Aufbringen einer Scheibe auf eine Halterungsplatte
Méthode d'application d'une galette sur un support de montage

(30) Priority: 21.12.1993 JP 344669/93
(43) Date of publication of application: 28.06.1995
(73) Proprietor: ENYA SYSTEMS LIMITED, Kawagoe-shi, Saitama-ken (JP)
(72) Inventor: Ooizumi, Kimiwaka, Sayama-shi, Saitama-ken (JP); Tanaka, Kouichi, Higashiyamato-shi, Tokyo (JP)
(74) Representative: Klingseisen, Franz, Dipl.-Ing.

(56) References cited:
- EP-A- 0 256 150
- US-A- 4 787 951
- PATENT ABSTRACTS OF JAPAN, vol. 12, no. 481 (E-694) 15 December 1988; & JP-A-63 198 351

## Description

### BACKGROUND OF THE INVENTION

### (1) Field of the Invention

The present invention relates to a method for applying a wafer such as a semiconductor wafer to a mount plate to be arranged into a polishing machine for polishing the surface of the wafer smooth. Particularly, it relates to a method for applying a wafer so that no bubbles are occluded between the wafer and the mount plate.

### (2) Background Information

Since semiconductor devices have become ultrahighly integrated, wafers used for such semiconductor devices are required to have an extremely high flatness. To obtain such a flatness with a high precision, the wafer is applied to a mount plate of a polishing machine with an adhesive to polish it by the polishing machine. However, when the wafer is applied, if bubbles are occluded into the adhesive between the wafer and the the mount plate, the wafer is bulged at the portion of the bubbles, whereby when polished, the abrasion amount at the portion of the bulges will be larger than the others and uniform and adequate polishing of entire surface will be impossible. Accordingly, many methods have been conducted to remove the bubbles.

As a method for removing bubbles, there have been conventionally known a method wherein a wafer is mounted on a mount plate and then bubbles are pressed out, and a method wherein a wafer is mounted on a mount plate, the area around the wafer is made in a vacuum condition and then the wafer is pressed against the mount plate. As the former method, for example, a method has been proposed wherein before the hardening of an adhesive, the wafer is gradually pressed against the mount plate with an elastic member from the central portion of the wafer toward the peripheral portion (Japanese Unexamined Utility Model Publication No. 4-88033). Further, as the latter method, for example, a method has been proposed wherein the area around the wafer is surrounded with a skirt portion and the inside of the skirt portion is made in a vacuum condition, and then the wafer is pressed against the mount plate in the vacuum atmosphere so that no bubbles will be occluded in the adhesive (Japanese Unexamined Patent Publication No. 64-45567).

As mentioned above, both the conventional methods have steps of pressing the wafer mounted on the mount plate against the mount plate with the elastic member or the like to exclude the bubbles, whereby the construction of controlling the adjustment of pressing force or the adjustment of the timing for pressing, etc. will become complicated. Further, since the wafer is thin, when the wafer is pressed, the pressed mark on the surface of wafer may sometimes remain as a small concave. Especially, in the method wherein the wafer held by suction with a vacuum chuck is pressed against the mount plate in the vacuum atmosphere by pressing down the vacuum chuck through a piston, the wafer is strongly pressed and whereby the pressed mark by the chuck is likely to remain on its surface. When polished, the pressed mark will form a concave portion and prevent uniform and smooth polishing of the entire surface of the wafer. Further, in the conventional methods, the wafer is pressed by having atmospheric pressure acted on the piston of the vacuum chuck, namely, the pressing is controlled by the relative pressure between the vacuum pressure of the vacuum chuck and the atmospheric pressure. Hence, the holding force or the pressing force depends on whether the weather condition is in a low atmospheric pressure or a high atmospheric pressure, whereby the wafer may drop or the pressing force may become insufficient during operation, which leads to troublesome adjustment.

### SUMMARY OF THE INVENTION

An object of the present invention is to provide a method for applying a wafer to a mount plate without positively pressing the wafer against the mount plate and containing bubbles between the wafer and the mount plate.

Another object of the present invention is to provide a method for applying a wafer to a mount plate wherein the wafer can be applied to the mount plate without employing conventional complicated processes or the relative pressure, having the pressed mark remained on the wafer and containing bubbles between the wafer and the mount plate.

According to the present invention, there is provided a method for applying a wafer to a mount plate which comprises, holding a wafer of which the under surface is provided with an adhesive, by a vacuum chuck through vacuum action, positioning the wafer close to the mount plate, and at the same time, providing a hood which surrounds the wafer to abut on the mount plate to define a sealed space section around the wafer, evacuating the space section surrounding the wafer at a degree of vacuum higher than the degree of vacuum of the vacuum chuck holding the wafer, thus causing the wafer to be dropped from the vacuum chuck onto the mount plate. The above objects and other objects can be thereby accomplished.

Other objects and features of the present invention will become apparent to those skilled in the art upon reading the following description with reference to the accompanying drawings.

### BRIEF DESCRIPTION OF THE DRAWINGS

Fig. 1 is a cross-sectional view of one example of a wafer mounting apparatus to which the present invention is applied.

Fig. 2 is a cross-sectional view of the wafer mounting apparatus as shown in Fig. 1 under the condition that the hood abuts on the mount plate, with parts broken away.

### DETAILED DESCRIPTION OF THE PREFERRED EMBODIMENTS

The drawings show one example of a mount apparatus to which the present invention is applied. A main body 1 is provided with a vacuum chuck 3 for holding a wafer 2 by suction and a hood 4 surrounding the wafer 2 which is held by the vacuum chuck 3. At the lower end of the hood 4, an elastic seal piece 7 is provided so that when the under end abuts on a mount plate 5, a space section 6 in the hood 4 will be sealed. The space section 6 of the hood 4 is preferably as small as possible so that the space section can be made rapidly in a vacuum condition. The inner diameter of the space section 6 of the hood 4 is formed slightly larger than the outer diameter of the wafer 2 to guide the dropping of the wafer with the inner wall surface of the hood.

In the drawings, the vacuum chuck 3 is fixedly provided to the main body 1. The wafer is supplied to the vacuum chuck fixedly provided in the hood 4 by an appropriate supplying means such as a robot, and held by suction. The hood 4 may be moved so that it will not obstruct the supplying of the wafer, whereby the vacuum chuck is exposed out of the hood to hold the wafer 2. Further, the vacuum chuck 3 may be arranged in an axially movable fashion by an appropriate mechanism such as a cylinder mechanism or a cam mechanism which is omitted in the drawings so that the vacuum chuck 3 will receive the wafer 2 at the position where it protrudes out of the hood 4 and house the wafer 2 within the hood 4 at the retracted position.

The vacuum chuck 3 and the space section 6 which surrounds the wafer 2 by the hood 4, communicate to a vacuum source (not shown) by way of valves 8, 9, respectively. The degree of vacuum of the vacuum chuck 3 is adjusted to be, preferably, from about 600 to about 650 mmHg (1mm Hg = 133Pa) so that it will hold by suction various wafers having different outer diameters. The degree of vacuum in the space section 6 is higher than the degree of vacuum of the vacuum chuck 3 by from about 90 to about 160 mmHg, preferably about 100mmHg, and is adjusted to be preferably from about 740 to about 760 mmHg so that it will sufficiently evacuates the space section 6. The difference in vaccum pressures may be further small according to the weight of the wafer.

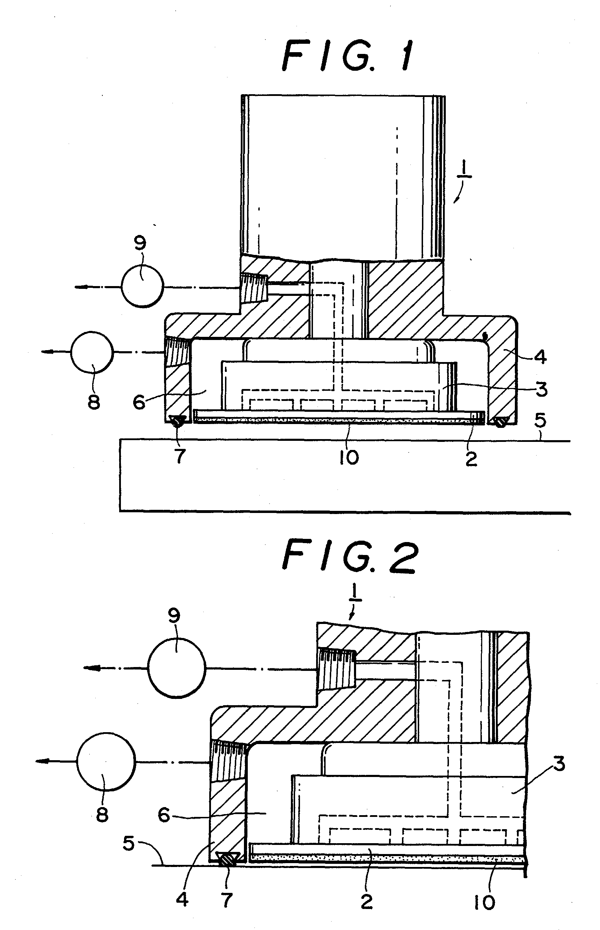

Then, the wafer 2 is held by suction by the vacuum chuck 3 under the condition that the hood 4 is in upward direction i.e. reverse direction to that of the condition as shown in Fig. 1. The main body 1 is turned to the condition as shown in Fig. 1. At the position of applying the wafer 2 to the mount plate 5, the main body 1 is lowered onto the mount plate 5 to have the seal piece 7 at the lower end of the hood 4 abutted on the mount plate 5 and make the wafer 2 close to the mount plate 5 (Fig. 2), and vice versa, i.e., the lower end of the hood 4 may be abutted on the mount plate 5 by placing the main body 1 fixedly and closing the mount plate 5 to the main body 1. The distance between the lower surface of the wafer 2 to which an adhesive 10 is applied and the upper surface of the mount plate 5, is desirably as small as possible, for for example, from about 0.2 to about 3 mm, preferably about 0.5 mm.

Under the condition that the space section 6 surrounding the wafer 2 is sealed as shown in Fig. 2, when the valve 8 is opened and the air within the space section 6 is sucked at the above-mentioned degree of vacuum, the air between the lower surface of the wafer 2 and the mount plate 5 will be removed. Then, at the time when the degree of vacuum in the space section 6 exceeds the degree of vacuum of the vacuum chuck 3, the wafer 2 drops from the chuck 3 and is applied to the mount plate 5 by the adhesive 10. Lines for sucking the space section 6 and the vacuum chuck 3 may be provided with pressure gauges, respectively. The dropping of the wafer can be confirmed when the indicated values of these pressure gauges become identical to each other. After that, an air is introduced into the space section and the main body 1 may be detached from the mount plate 5.

The present invention is constructed as mentioned above, and no bubbles are occluded into the adhesive between the wafer and the mount plate by sucking the air in the space section surrounding the wafer. Furthermore, since the degree of vacuum in the space section is made higher than the degree of vacuum of the vacuum chuck which holds the wafer by suction, the wafer will drop from the vacuum chuck to the mount plate by the difference in the degrees of vacuum without pressing the vacuum chuck against the mount plate, and the wafer can be applied to the mount plate by the adhesive which is coated on the lower surface of the wafer. According to the present invention wherein the holding and application of the wafer can be controlled by absolute pressure by using only vacuum pressure, the application can be conducted surely without being influencedby environmental weather or phenomenon. Accordingly, no pressed mark by the chuck will remain unlike the conventional methods, whereby a wafer having a flatness of a high precision can be obtained. Further, no such a construction that the wafer is pressed against the mount plate as the conventional methods is required, whereby the wafer can be applied to the mount plate by an entirely simple apparatus.

## Claims

1. A method for applying a wafer (2) to a mount plate (5) comprising the following steps:
a wafer (2) whose under surface is provided with an adhesive (10) is held by a vacuum chuck (3) through vacuum action,
a hood (4) is provided which surrounds the wafer (2) to abut on the mount plate (5) to define a sealed space section (6) around the wafer (2), and at the same time, the under surface of the wafer (2) is positioned close to the mount plate (5),
the space section (6) is evacuated at a degree of vacuum higher than the degree of vacuum of the vacuum chuck (3), and
the wafer (2) is thus caused to drop from the vacuum chuck (3) onto the mount plate (5) by the difference in the degrees of vacuum.

2. The method according to Claim 1, wherein the degree of vacuum of the space section (6) is higher than the degree of vacuum of the vacuum chuck (3) by from 1·2x10⁴ - 2·13x10⁴ Pa (90 to 160 mmHg).

3. The method according to Claim 1, wherein the wafer (2) drops onto the mount plate (5) from a height of from 0.2 to 3 mm above the upper surface of the mount plate (5).

## Patentansprüche

1. Verfahren zum Aufbringen einer Scheibe (2) auf eine Halterungsplatte (5), das folgende Schritte aufweist:
eine Scheibe (2), deren Unterseite mit einem Klebstoff (10) versehen ist, wird von einem Unterdruckspannfutter (3) durch Vakuumbeaufschlagung gehalten,
eine Kappe (4) wird angebracht, die die Scheibe (2) umgibt und an der Halterungsplatte (5) angrenzt und so einen abgeschlossenen Raum (6) um die Scheibe (2) bildet, wobei die Unterseite der Scheibe (2) gleichzeitig in der Nähe der Halterungsplatte (5) positioniert wird,
der Raum (6) wird entleert bis zu einem Vakuumgrad, der höher ist als der Vakuumgrad des Vakuumspannfutters (3) so daß durch den Unterschied im Vakuumgrad die Scheibe (2) von dem Vakuumspannfutter (3) auf die Halterungsplatte (5) fällt.

2. Verfahren nach Anspruch 1,
wonach der Vakuumgrad des Raums (6) um von 1.2 x 10⁴ bis 2.13x 10⁴ Pa ( 90 - 160 mmHg) höher ist als der Vakuumgrad des Vakuumspannfutters (3).

3. Verfahren nach Anspruch 1,
wonach die Scheibe (2) von einer Höhe von 0,2 bis 3mm oberhalb der oberen Oberfläche der Halterungsplatte (5) auf die Halterungsplatte (5) fällt.

## Revendications

1. Méthode d'application d'une galette (2) sur un support de montage (5) comprenant les étapes comme suit:
une galette (2) le dessous de laquelle est muni d'un gluten (10) est tenu par un vacuum mandrin de serrage (3) par vacuum activité,
un chapeau (4) est muni entournant la galette (2) et confinant au support de montage (5) pour former un espace isolé (6) autour de la galette (2), le dessous de la galette (2) étant positionné en même temps au voisinage du support de montage (5),
l'espace (6) est evacué jusqu' à un vacuum degré qui est plus haut que le vacuum degré du vacuum mandrin de serrage (3) de manière que la galette (2) tombe du vacuum mandrin de serrage (3) au support de montage (5) par la difference en degrés du vacuum.

2. Méthode selon la revendication 1,
le degré du vacuum de l'espace (6) étant plus haut que le degré du vacuum du mandrin de serrage (3) par de 1,2 x 10⁴ à 2,13 x 10⁴ Pa ( 90 à 160 mmHg).

3. Méthode selon la revendication 1,
selon la galette (2) tombe au support de montage (5) d'une hauteur de 0,2 à 3 mm au-dessus de la surface supérieure du support de montage (5).
